# EUROPEAN PATENT APPLICATION

(11) **EP 4 009 376 A1**
(43) Date of publication of application: **08.06.2022**
(21) Application number: 21195936.6
(22) Date of filing: 10.09.2021
(51) Int. Cl.: H01L 29/45, H01L 29/786

(54) **TRANSISTOR SOURCE/DRAIN CONTACTS**

(30) Priority: 07.12.2020 US 202017114034
(71) Applicant: INTEL Corporation, Santa Clara, CA 95054 (US)
(72) Inventor: KU, Chieh-Jen, Portland, 97229 (US); SOUTHER, Kendra, Portland, 97201 (US); BARAN, Andre, Portland, 97229 (US); Wang, Pei-Hua, Beaverton, 97006 (US); SELL, Bernhard, Portland, 97229 (US)
(74) Representative: Goddar, Heinz J.

(57) **Abstract**

Disclosed herein are transistor source/drain contacts, and related methods and devices. For example, in some embodiments, a transistor may include a channel and a source/drain contact, wherein the source/drain contact includes an interface material and a bulk material, the bulk material has a different material composition than the interface material, the interface material is between the bulk material and the channel, the interface material includes indium and an element different from indium, and the element is aluminum, vanadium, zirconium, magnesium, gallium, hafnium, silicon, lanthanum, tungsten, or cadmium.

## Description

### Background

Thin-film transistors may include a semiconducting channel proximate to a gate. Source/drain contacts may contact the semiconducting channel.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a side, cross-sectional view of a transistor channel-source/drain contact arrangement, in accordance with various embodiments.
FIGS. 2-5 are side, cross-sectional views of example transistors including a transistor channel-source/drain contact arrangement, in accordance with various embodiments.
FIG. 6 is a flow diagram of an example method of manufacturing a source/drain interface material, in accordance with various embodiments.
FIG. 7 is a top view of a wafer and dies that may include a transistor channel-source/drain contact arrangement in accordance with any of the embodiments disclosed herein.
FIG. 8 is a side, cross-sectional view of an integrated circuit (IC) device that may include a transistor channel-source/drain contact arrangement in accordance with any of the embodiments disclosed herein.
FIG. 9 is a side, cross-sectional view of an IC package that may include a transistor channel-source/drain contact arrangement in accordance with various embodiments.
FIG. 10 is a side, cross-sectional view of an IC device assembly that may include a transistor channel-source/drain contact arrangement in accordance with any of the embodiments disclosed herein.
FIG. 11 is a block diagram of an example electrical device that may include a transistor channel-source/drain contact arrangement in accordance with any of the embodiments disclosed herein.

### Detailed Description

Disclosed herein are transistor source/drain contacts, and related methods and devices. For example, in some embodiments, a transistor may include a channel and a source/drain contact, wherein the source/drain contact includes an interface material and a bulk material, the bulk material has a different material composition than the interface material, the interface material is between the bulk material and the channel, the interface material includes indium and an element different from indium, and the element is aluminum, vanadium, zirconium, magnesium, gallium, hafnium, silicon, lanthanum, tungsten, or cadmium.

The materials and structures of thin-film transistors (TFTs), when initially fabricated, may be negatively impacted by the higher temperatures experienced by the TFTs during subsequent manufacturing operations. For example, the higher temperatures of subsequent manufacturing operations may cause voids to form between the source/drain contacts and the channel of a TFT. Such voids may compromise electrical performance of the TFT, leading to low yields for devices that incorporate such TFTs. These consequences may be particularly acute for back-end (or "back-end-of-line" (BEOL)) TFTs.

The transistor channel-source/drain contact arrangements disclosed herein may improve the thermal stability of TFTs, reducing the defects arising during subsequent thermal process steps and thereby improving device performance and increasing yield. Various ones of the transistor channel-source/drain arrangements disclosed herein may include a source/drain interface material having a greater bandgap than conventional interface materials, providing increased thermal stability without substantially increasing material cost or manufacturing complexity. Consequently, the transistor channel-source/drain contact arrangements disclosed herein may achieve electrical performance and yields not achievable using conventional approaches.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). For the purposes of the present disclosure, the phrase "A, B, or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. As used herein, a "high-k dielectric" refers to a material having a higher dielectric constant than silicon oxide. As used herein, the term "conductive" means "electrically conductive" unless otherwise specified. As used herein, the term "material" may include one material or multiple materials having different material compositions.

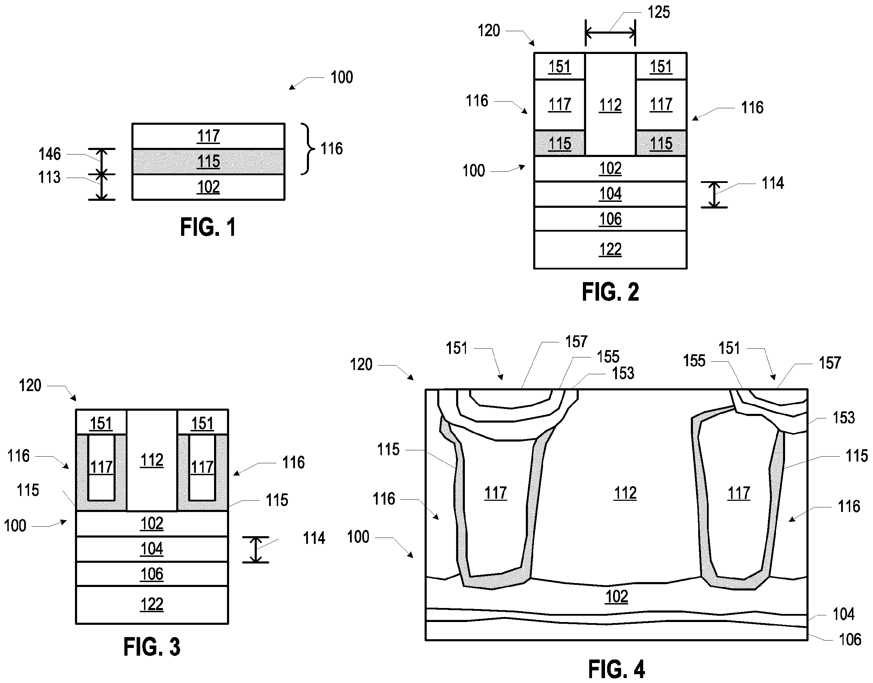

FIG. 1 is a side, cross-sectional view of a transistor channel-source/drain contact arrangement 100 including a channel 102 and a source/drain contact 116, in accordance with various embodiments. The source/drain contact 116 may include a source/drain interface material 115 and a source/drain bulk material 117, with the source/drain interface material 115 between the channel 102 and the source/drain bulk material 117.

The channel 102 may be composed of semiconductor material systems including, for example, n-type or p-type materials systems. The channel 102 may include a semiconductor material (e.g., an oxide semiconductor material). In some embodiments, the channel 102 may include indium, gallium, zinc, and oxygen (e.g., in the form of indium gallium zinc oxide (IGZO)). In some embodiments, the channel 102 may include tin and oxygen (e.g., in the form of tin oxide); antimony and oxygen (e.g., in the form of antimony oxide); indium and oxygen (e.g., in the form of indium oxide); indium, tin, and oxygen (e.g., in the form of indium tin oxide); titanium and oxygen (e.g., in the form of titanium oxide); zinc and oxygen (e.g., in the form of zinc oxide); indium, zinc, and oxygen (e.g., in the form of indium zinc oxide); gallium and oxygen (e.g., in the form of gallium oxide); titanium, oxygen, and nitrogen (e.g., in the form of titanium oxynitride); ruthenium and oxygen (e.g., in the form of ruthenium oxide); or tungsten and oxygen (e.g., in the form of tungsten oxide). The channel 102 may have a thickness 113. In some embodiments, the thickness 113 may be between 5 nanometers and 30 nanometers.

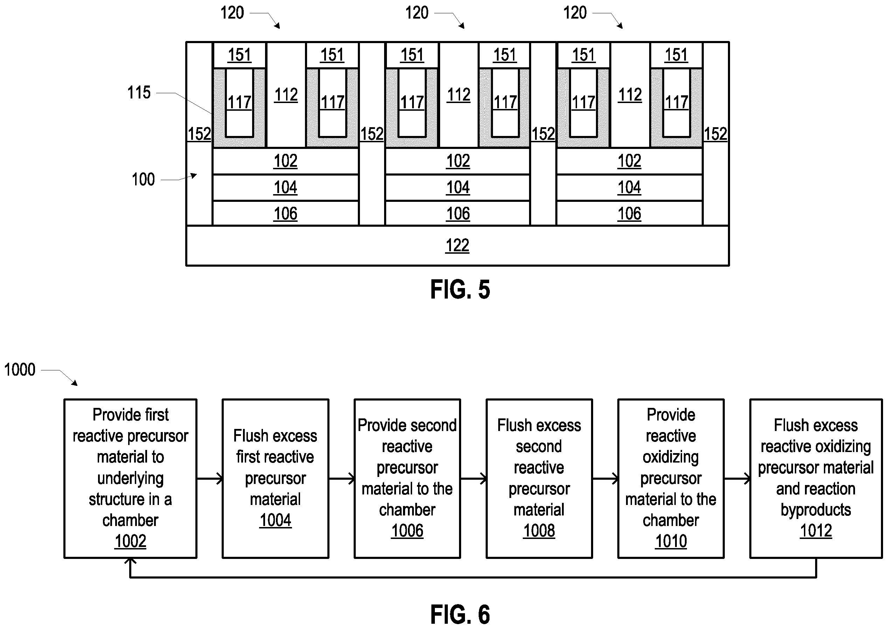

As noted above, a transistor channel-source/drain contact arrangement 100 may include a source/drain contact 116 including a source/drain interface material 115 and a source/drain bulk material 117. The source/drain bulk material 117 may include any desired material (e.g., one or more conductive metals). In some embodiments, the source/drain bulk material 117 may include copper, molybdenum, tungsten, indium oxide, or indium zinc oxide. The source/drain interface material 115 may include a conductive oxide, such as an indium-based oxide. In some embodiments, the source/drain interface material 115 may include indium and oxygen (e.g., in the form of indium oxide); indium, zinc, and oxygen (e.g., in the form of indium zinc oxide); or indium, tin, and oxygen (e.g., in the form of indium tin oxide). The source/drain interface material 115 may further include an additional element. This additional element may increase the bandgap of the conductive oxide of the source/drain interface material 115, increasing the thermal stability of the source/drain interface material 115, as discussed above. In some embodiments, the additional element may be a metal element, such as aluminum, vanadium, zirconium, magnesium, hafnium, lanthanum, tungsten, or cadmium. In other embodiments, the additional element may be a semiconductor element, such as silicon or gallium. In some particular embodiments, the element may be aluminum, while in other particular embodiments, the element may be cadmium. The additional element may be incorporated into the source/drain interface material 115 in any desired manner (e.g., using the atomic deposition processes discussed below with reference to FIG. 6).

The source/drain interface material 115 may be conductive; as such, in some embodiments, the amount of the additional element included in the source/drain interface material 115 may be constrained so as to maintain conductivity of the source/drain interface material 115 (i.e., to avoid causing the source/drain interface material 115 to become electrically insulating). For example, in some embodiments, the additional element may be present in the source/drain interface material 115 in an amount between 5 atomic-percent and 20 atomic-percent. In some embodiments, the additional element may be distributed uniformly through the source/drain interface material 115, while in other embodiments, the additional element may be non-uniformly distributed through the source/drain interface material 115. For example, the source/drain interface material 115 may include a gradient of the additional element, with lower concentrations of the additional element closer to the channel 102 and increasing concentrations of the additional element away from the channel 102. Some such embodiments may desirably reduce electrical resistance at the interface between the source/drain contact 116 and the channel 102. In some embodiments, a thickness 146 of the source/drain interface material 115 may be between 1 nanometer and 5 nanometers.

A transistor channel-source/drain contact arrangement 100 may be included in any suitable transistor structure. For example, FIGS. 2-4 are side, cross-sectional views of example transistors 120 (e.g., TFTs) including a transistor channel-source/drain contact arrangement 100, and FIG. 5 is a side, cross-sectional view of an example array of transistors 120 including transistor channel-source/drain contact arrangements 100. The transistors 120 illustrated in FIGS. 2-5 do not represent an exhaustive set of transistor structures in which a transistor channel-source/drain contact arrangement 100 may be included, but provide examples of such transistor structures. Note that FIGS. 2-5 are intended to show relative arrangements of the components therein, and that transistors 120 may include other components that are not illustrated (e.g., electrical contacts to the gate electrode 106, etc.). Any of the components of the transistors 120 discussed below with reference to FIGS. 2-5 may take the form of any of the embodiments of those components discussed above with reference to FIG. 1. Additionally, although various components of the transistors 120 are illustrated in FIGS. 2-5 as being planar rectangles or formed of rectangular solids, this is simply for ease of illustration, and embodiments of these transistors 120 may be curved, rounded, or otherwise irregularly shaped as dictated by the manufacturing processes used to fabricate the transistors 120.

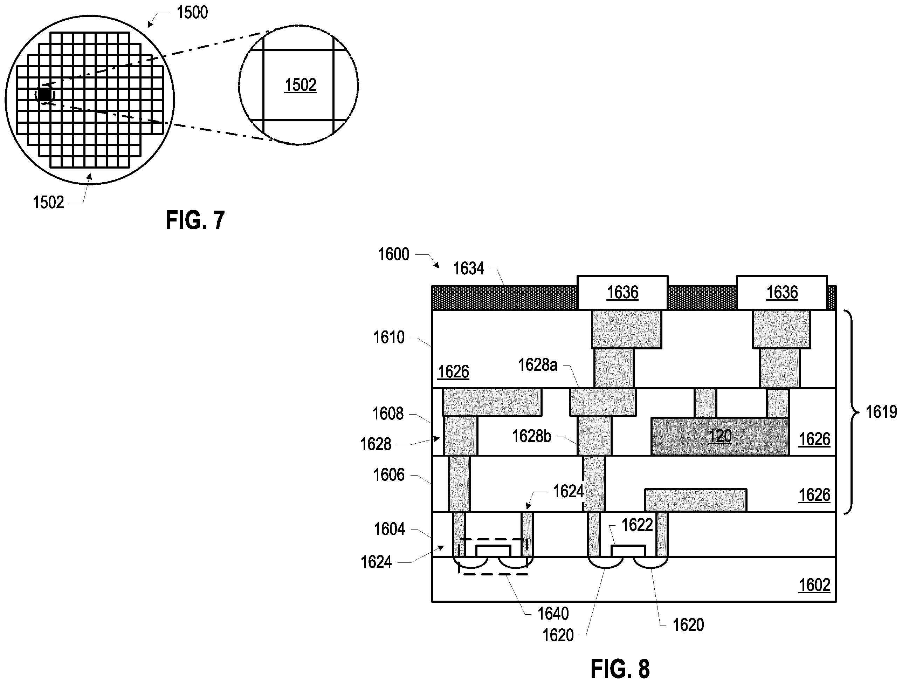

FIG. 2 depicts a transistor 120 including a transistor channel-source/drain contact arrangement 100 and having a "bottom" gate provided by a gate electrode 106 and a gate dielectric 104. The gate dielectric 104 may be disposed between the gate electrode 106 and the channel 102. In the embodiment of FIG. 2, the gate electrode 106 may be disposed between an underlying structure 122 and the channel 102. The underlying structure 122 may be any structure on which the transistor channel-source/drain contact arrangement 100, or other elements of the transistor 120, is disposed. In some embodiments, the underlying structure 122 may include a semiconductor, such as silicon. In some embodiments, the underlying structure 122 may include an insulating layer, such as an oxide isolation layer, or one or more layers of a metallization stack (e.g., when the transistor 120 is a back-end transistor, as discussed below with reference to FIG. 8). For example, the underlying structure 122 may include a semiconductor material (e.g., any of the materials discussed below with reference to the substrate 1602 of FIG. 8) and an interlayer dielectric (ILD) in one or more metallization layers (e.g., discussed below with reference to FIG. 8) disposed between the semiconductor material and the source/drain contacts 116 and the channel 102. Any suitable ones of the embodiments of the underlying structure 122 described with reference to FIG. 2 may be used for the underlying structures 122 of others of the transistors 120 disclosed herein.

The transistor 120 of FIG. 2 may include source/drain contacts 116 disposed on the channel 102 such that the source/drain contacts 116 are not coplanar with the channel 102. As discussed above with reference to FIG. 1, the source/drain interface material 115 may be between the channel 102 and the source/drain bulk material 117. The source/drain contacts 116 may be spaced apart by an intervening insulating material 112, and the source/drain contacts 116 may be spaced apart by a distance 125 that may be, for example, between 20 nanometers and 30 nanometers (e.g., between 22 nanometers and 28 nanometers, or approximately 25 nanometers).

The insulating material 112 may include any suitable dielectric materials. In some embodiments, the insulating material 112 may include an ILD, which may include silicon and oxygen (e.g., in the form of silicon oxide); silicon and nitrogen (e.g., in the form of silicon nitride); aluminum and oxygen (e.g., in the form of aluminum oxide); and/or silicon, oxygen, and nitrogen (e.g., in the form of silicon oxynitride).

The transistor 120 of FIG. 2 (and others of the accompanying drawings) may include interconnects 151 in conductive contact with the source/drain contacts 116. The interconnects 151 may serve as electrical contacts to the source/drain contacts 116 to transport current in and out of the transistors 120. The interconnects 151 may include any suitable materials, such as tungsten, tantalum, copper, or other conductive materials. A particular example of interconnects 151 is discussed below with reference to FIG. 4; any of the embodiments of the interconnects 151 disclosed herein may be utilized with any of the transistors 120 disclosed herein.

The gate electrode 106 may include at least one p-type work function metal or n-type work function metal, depending on whether the transistor channel-source/drain contact arrangement 100 is to be included in a p-type metal oxide semiconductor (PMOS) transistor or an n-type metal oxide semiconductor (NMOS) transistor. For a PMOS transistor, metals that may be used for the gate electrode 106 may include, but are not limited to, ruthenium, palladium, platinum, cobalt, nickel, and conductive metal oxides (e.g., ruthenium oxide). For an NMOS transistor, metals that may be used for the gate electrode 106 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 106 may consist of a stack of two or more metal layers, where one or more metal layers are work function metal layers and at least one metal layer is a fill metal layer. Further metal layers may be included for other purposes, such as to act as a barrier layer.

The gate dielectric 104 may be between the channel 102 and the gate electrode 106 (e.g., may be in contact with the channel 102 and the gate electrode 106). The gate dielectric 104 may be a high-k dielectric, and may include one or more layers of material. The gate dielectric 104 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 104 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 104 during manufacture of the transistor channel-source/drain contact arrangement 100 to improve the quality of the gate dielectric 104. The gate dielectric 104 may have a thickness 114. In some embodiments, the thickness 114 may be between 0.5 nanometers and 3 nanometers (e.g., between 1 nanometer and 3 nanometers, or between 1 nanometer and 2 nanometers).

FIG. 3 depicts another transistor 120 including a transistor channel-source/drain contact arrangement 100 and having a "bottom" gate provided by the gate electrode 106 and the gate dielectric 104. The transistor 120 of FIG. 3 shares many features with the transistor 120 of FIG. 2 (including the source/drain interface material 115 between the channel 102 and the source/drain bulk material 117), but in the transistor 120 of FIG. 3, the source/drain interface material 115 may have a U-shaped cross-section, extending conformally up the side faces of the adjacent insulating material 112.

FIG. 4 depicts a transistor 120 having the structure of the transistor 120 of FIG. 3. In particular, the transistor 120 of FIG. 4 includes a transistor channel-source/drain contact arrangement 100, has a single "bottom" gate provided by the gate electrode 106 and the gate dielectric 104, and the source/drain contacts 116 are in contact with the channel 102 (with the source/drain interface material 115 having a U-shaped cross-section, and being between the source/drain bulk material 117 and the channel 102). Interconnects 151 are in contact with the source/drain contacts 116. In the particular embodiment illustrated in FIG. 4, the interconnects 151 include a first liner material 153, a second liner material 155 having a different material composition than the first liner material 153, and a bulk material 157; the first liner material 153 may be between the second liner material 155 and the associated source/drain contact 116, and the second liner material 155 may be between the first liner material 153 and the bulk material 157. The first liner material 153, the second liner material 155, and the bulk material 157 may include any suitable materials. In some embodiments, for example, the first liner material 153 includes tungsten, the second liner material 155 includes tantalum, and the bulk material 157 includes copper. The transistor 120 of FIG. 5 may also include an underlying structure 122 (not shown) arranged so that the gate electrode 106 is disposed between the underlying structure 122 and the gate dielectric 104.

Any of the transistors 120 disclosed herein may be included in an array of transistors 120. Such an array of transistors 120 may be part of an array of memory cells including those transistors 120 (e.g., an array of dynamic random access memory (DRAM) cells that also include capacitors, not shown). For example, FIG. 5 is a side, cross-sectional view of an array of transistors 120. In particular, the transistors 120 included in FIG. 5 are the transistors 120 of FIGS. 3 and 4, but any of the transistors 120 disclosed herein may be arranged in an array as illustrated in FIG. 5. Adjacent transistors 120 may be separated by insulating material 152, which may include any suitable dielectric material (e.g., an ILD or other isolation material).

The source/drain contacts 116 (and the associated transistor channel-source/drain contact arrangements 100) disclosed herein may be manufactured using any suitable techniques. For example, FIG. 6 is a flow diagram of an example atomic deposition method 1000 of manufacturing a source/drain interface material, in accordance with various embodiments. Although the operations of the method 1000 are illustrated once each and in a particular order, the operations may be performed in any suitable order and repeated as desired. For example, one or more operations may be performed in parallel to manufacture multiple source/drain interface materials substantially simultaneously. Further, although the method 1000 may be illustrated by reference to particular embodiments of the source/drain interface materials 115 disclosed herein, the method 1000 may be used to form any suitable source/drain interface material.

At 1002, a first reactive precursor material may be provided to an underlying structure in a chamber. For example, the underlying structure may have the channel 102 of a transistor 120 exposed at a surface on which the source/drain contacts may be formed. The first reactive precursor material may include a metal. For example, the first reactive precursor material may include indium (e.g., in the form of trimethylindium). The first reactive precursor material may absorb to the exposed surface of the underlying structure.

At 1004, excess first reactive precursor material may be flushed. For example, a purge gas may be supplied to the chamber to flush the excess first reactive precursor material from the surface of the underlying structure and from the chamber volume.

At 1006, a second reactive precursor material may be provided to the chamber. The second reactive precursor material may include the additional element to be included in the source/drain contact (e.g., as discussed above with reference to FIG. 1). For example, the second reactive precursor material may include aluminum (e.g., in the form of trimethylaluminum), vanadium, zirconium, magnesium, hafnium, lanthanum, tungsten, cadmium, silicon, or gallium. The operations of 1006 may be performed, for example, when the operations at 1002 do not achieve full absorption site coverage on the exposed surface on the underlying structure; in such embodiments, the second reactive precursor material may absorb to the "unfilled" sites on the exposed surface of the underlying structure.

At 1008, excess second reactive precursor material may be flushed. For example, a purge gas may be supplied to the chamber to flush the excess second reactive precursor material from the surface of the underlying structure and from the chamber volume.

At 1010, a reactive oxidizing precursor material may be provided to the chamber. The reactive oxidizing precursor material may react with the first reactive precursor material absorbed to the exposed surface of the underlying structure, forming a monolayer of a doped binary thin-film conductive oxide. The reactive oxidizing precursor material may include oxygen (e.g., in the form of ozone gas).

At 1012, excess reactive oxidizing precursor material (and reaction byproducts) may be flushed. For example, a purge gas may be supplied to the chamber to flush the excess reactive oxidizing precursor material from the surface of the underlying structure and from the chamber volume. The process may then return to 1002 to continue deposition operations until a source/drain interface material (e.g., a source/drain interface material 115) of a desired thickness is formed. In some embodiments, some number of cycles of the operations of 1002-1012 may alternate with some number of cycles of the operations of 1002-1004 and 1010-1012 (omitting the second reactive precursor material of operations 1006-1008) to achieve a desired gradient of conductive metal oxide and binary conductive metal oxide in the film stack of the source/drain interface material (and thereby achieve a desired gradient of the additional element in the source/drain interface material).

The transistor channel-source/drain contact arrangements 100 and transistors 120 disclosed herein may be included in any suitable electronic component. FIGS. 7-11 illustrate various examples of apparatuses that may include any of the transistor channel-source/drain contact arrangements 100 and transistors 120 disclosed herein.

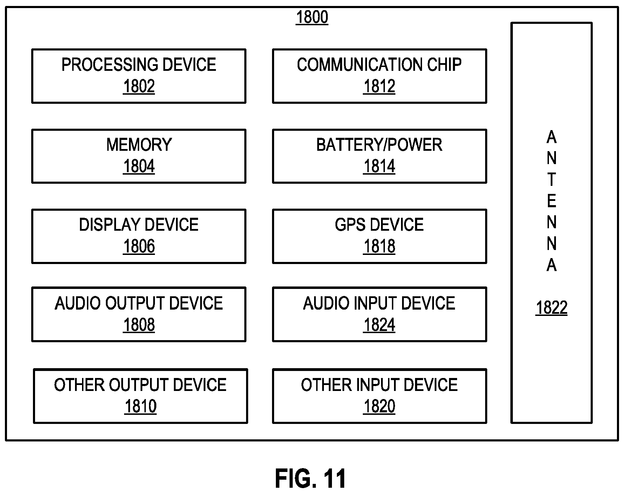

FIG. 7 is a top view of a wafer 1500 and dies 1502 that may include one or more transistor channel-source/drain contact arrangements 100 in accordance with any of the embodiments disclosed herein. The wafer 1500 may be composed of semiconductor material and may include one or more dies 1502 having integrated circuit (IC) structures formed on a surface of the wafer 1500. Each of the dies 1502 may be a repeating unit of a semiconductor product that includes any suitable IC (e.g., ICs including one or more of any of the transistors 120 disclosed herein). After the fabrication of the semiconductor product is complete, the wafer 1500 may undergo a singulation process in which the dies 1502 are separated from one another to provide discrete "chips" of the semiconductor product. In particular, devices that include a transistor channel-source/drain contact arrangement 100 as disclosed herein may take the form of the wafer 1500 (e.g., not singulated) or the form of the die 1502 (e.g., singulated). The die 1502 may include one or more transistors (e.g., one or more of the transistors 120 or the transistors 1640 discussed below with reference to FIG. 8) and/or supporting circuitry to route electrical signals to the transistors, as well as any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 11) or other logic that is configured to store information in the memory devices or execute instructions stored in the memory array.

FIG. 8 is a side, cross-sectional view of an IC device 1600 that may include one or more transistor channel-source/drain contact arrangements 100 and/or transistors 120 in accordance with any of the embodiments disclosed herein. One or more of the IC devices 1600 may be included in one or more dies 1502 (FIG. 7). The IC device 1600 may be formed on a substrate 1602 (e.g., the wafer 1500 of FIG. 7) and may be included in a die (e.g., the die 1502 of FIG. 7). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 7) or a wafer (e.g., the wafer 1500 of FIG. 7).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source/drain contacts 1620, a gate 1622 to control current flow in the transistors 1640 between the source/drain contacts 1620, and one or more interconnects 1624 to route electrical signals to/from the source/drain contacts 1620. The transistors 1640 may include additional features not depicted for the sake of clarity, such as device isolation regions, gate contacts, and the like. The transistors 1640 are not limited to the type and configuration depicted in FIG. 8 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors. In some embodiments, one or more of the transistors 1640 may include one or more transistor channel-source/drain contact arrangements 100 in accordance with any of the embodiments disclosed herein. For example, a transistor 1640 may take the form of any of the transistors 120 disclosed herein. In some embodiments, the source/drain contacts 1620 may include any of the source/drain contacts 116 disclosed herein (e.g., including any of the source/drain interface materials 115 disclosed herein). Transistors 120 including the transistor channel-source/drain contact arrangements 100 disclosed herein may be particularly advantageous when used in the metal layers of a microprocessor device for analog circuitry, logic circuitry, or memory circuitry, and may be formed along with existing complementary metal oxide semiconductor (CMOS) processes.

Each transistor 1640 may include a gate 1622 formed of at least two layers, a gate dielectric layer and a gate electrode layer. The gate electrode layer may take the form of any of the embodiments of the gate electrode 106 disclosed herein. The gate dielectric layer may take the form of any of the embodiments of the gate dielectric 104 disclosed herein. Generally, the gate dielectric layer of a transistor 1640 may include one layer or a stack of layers, and the one or more layers may include silicon oxide, silicon dioxide, silicon carbide, and/or a high-k dielectric material.

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers. In some embodiments, the gate electrode may consist of a V-shaped structure (e.g., when the fin does not have a "flat" upper surface, but instead has a rounded peak).

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The source/drain contacts 1620 may be formed within the substrate 1602 adjacent to the gate 1622 of each transistor 1640. In some embodiments, the source/drain contacts 1620 may take the form of any of the embodiments of the source/drain contacts 116 discussed above with reference to the transistors 120. In other embodiments, the source/drain contacts 1620 may be formed using any other suitable processes known in the art. For example, the source/drain contacts 1620 may be formed using an implantation/diffusion process or an etching/deposition process, for example. In the former process, dopants such as boron, aluminum, antimony, phosphorous, or arsenic may be ion-implanted into the substrate 1602 to form the source/drain contacts 1620. An annealing process that activates the dopants and causes them to diffuse farther into the substrate 1602 may follow the ion-implantation process. In the latter process, the substrate 1602 may first be etched to form recesses at the locations of the source/drain contacts 1620. An epitaxial deposition process may then be carried out to fill the recesses with material that is used to fabricate the source/drain contacts 1620. In some implementations, the source/drain contacts 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the source/drain contacts 1620 may be formed using one or more alternate semiconductor materials such as germanium or a group III-V material or alloy. In further embodiments, one or more layers of metal and/or metal alloys may be used to form the source/drain contacts 1620.

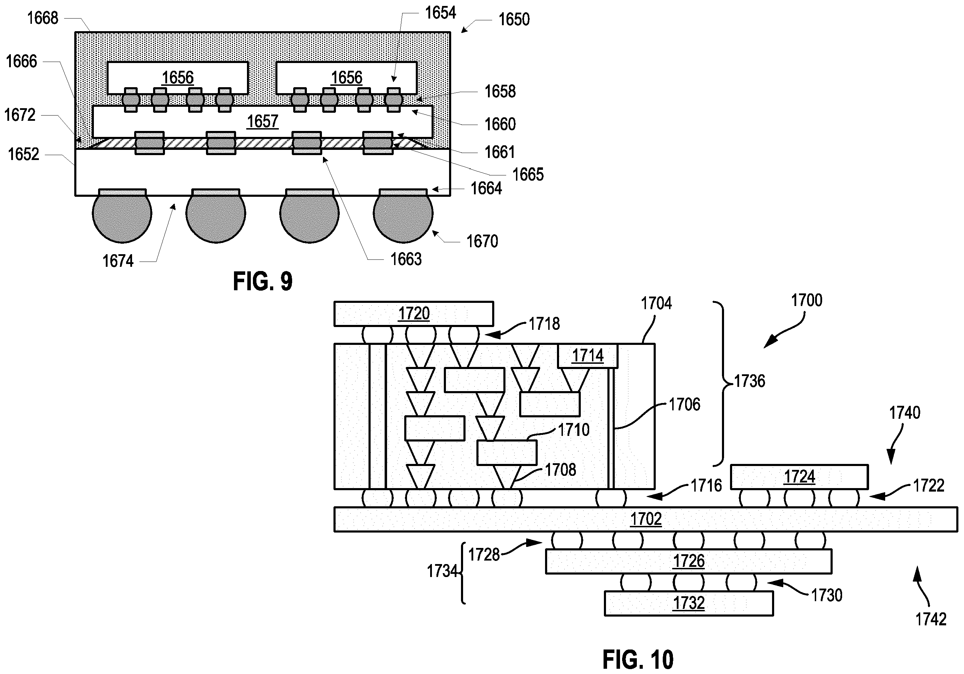

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 8 as interconnect layers 1606-1610). For example, electrically conductive features of the device layer 1604 (e.g., the gate 1622 and the interconnects 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600. In some embodiments, one or more transistors 120 may be disposed in one or more of the interconnect layers 1606-1610, in accordance with any of the techniques disclosed herein. FIG. 8 illustrates a single transistor 120 in the interconnect layer 1608 for illustration purposes, but any number and structure of transistors 120 may be included in any one or more of the layers in a metallization stack 1619 (e.g., an array of transistors 120, as illustrated in FIGS. 9-10). A transistor 120 included in the metallization stack 1619 may be referred to as a "back-end" device. One or more transistors 120 in the metallization stack 1619 may be coupled to any suitable ones of the devices in the device layer 1604, to other components (e.g., a capacitor in the metallization stack 1619 as part of a DRAM cell) and/or to one or more of the conductive contacts 1636 (discussed below).

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 8). Although a particular number of interconnect layers 1606-1610 is depicted in FIG. 8, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 8. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 8. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the interconnects 1624) of the device layer 1604. The interconnects 1624 may take the form of any of the interconnects 151 disclosed herein, in some embodiments.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 8, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

FIG. 9 is a side, cross-sectional view of an example IC package 1650 that may include one or more transistor channel-source/drain contact arrangements 100 and/or transistors 120 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 8.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to other devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 9 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 9 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 9 are solder balls (e.g., for a ball grid array arrangement), but any suitable second-level interconnects 16770 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 10.

The dies 1656 may take the form of any of the embodiments of the die 1502 discussed herein (e.g., may include any of the embodiments of the IC device 1600, and may include any of the transistor channel-source/drain contact arrangements 100 and/or transistors 120 disclosed herein). In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high bandwidth memory).

Although the IC package 1650 illustrated in FIG. 9 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 9, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 10 is a side, cross-sectional view of an IC device assembly 1700 that may include one or more IC packages or other electronic components (e.g., a die) including one or more transistor channel-source/drain contact arrangements 100 and/or transistors 120 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 9 (e.g., may include one or more transistor channel-source/drain contact arrangements 100 and/or transistors 120 in a die).

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 10 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 10), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 10, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 7), an IC device (e.g., the IC device 1600 of FIG. 8), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 10, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 10 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 11 is a block diagram of an example electrical device 1800 that may include one or more transistor channel-source/drain contact arrangements 100 and/or transistors 120 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 11 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 11, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., DRAM), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 is a back-end transistor, including: a channel; and a source/drain contact, wherein the source/drain contact includes an interface material and a bulk material, the bulk material has a different material composition than the interface material, the interface material is between the bulk material and the channel, the interface material includes indium and an element different from indium, and the element is aluminum, vanadium, zirconium, magnesium, gallium, hafnium, silicon, lanthanum, tungsten, or cadmium.

Example 2 includes the subject matter of Example 1, and further specifies that the element is aluminum.

Example 3 includes the subject matter of Example 1, and further specifies that the element is cadmium.

Example 4 includes the subject matter of any of Examples 1-3, and further specifies that the interface material includes zinc.

Example 5 includes the subject matter of any of Examples 1-3, and further specifies that the interface material includes tin.

Example 6 includes the subject matter of any of Examples 1-5, and further specifies that the interface material includes oxygen.

Example 7 includes the subject matter of any of Examples 1-6, and further specifies that the element is present in the interface material in a concentration between 5 atomic-percent and 20 atomic-percent.

Example 8 includes the subject matter of any of Examples 1-7, and further specifies that the interface material is conductive.

Example 9 includes the subject matter of any of Examples 1-8, and further specifies that the interface material has a U-shaped cross-section.

Example 10 includes the subject matter of any of Examples 1-9, and further specifies that the channel includes indium.

Example 11 includes the subject matter of any of Examples 1-10, and further specifies that the channel includes gallium.

Example 12 includes the subject matter of any of Examples 1-11, and further specifies that the channel includes zinc.

Example 13 includes the subject matter of any of Examples 1-12, and further specifies that the bulk material includes copper.

Example 14 includes the subject matter of any of Examples 1-13, and further includes: a gate including a gate dielectric and a gate electrode, wherein the gate dielectric is between the channel and the gate electrode.

Example 15 includes the subject matter of Example 14, and further specifies that the gate dielectric includes hafnium.

Example 16 includes the subject matter of any of Examples 14-15, and further specifies that the gate electrode includes titanium.

Example 17 includes the subject matter of any of Examples 1-16, and further specifies that the source/drain contact is a first source/drain contact, and the transistor further includes: a second source/drain contact.

Example 18 includes the subject matter of Example 17, and further specifies that the second source/drain contact has a same material arrangement as the first source/drain contact.

Example 19 includes the subject matter of any of Examples 17-18, and further includes: an insulating material between the first source/drain contact and the second source/drain contact.

Example 20 includes the subject matter of Example 19, and further specifies that the insulating material includes an interlayer dielectric.

Example 21 includes the subject matter of any of Examples 19-20, and further specifies that the insulating material includes oxygen.

Example 22 includes the subject matter of any of Examples 19-21, and further specifies that the insulating material includes silicon or aluminum.

Example 23 includes the subject matter of any of Examples 19-20, and further specifies that the insulating material includes nitrogen.

Example 24 includes the subject matter of Example 23, and further specifies that the insulating material includes silicon.

Example 25 includes the subject matter of Example 24, and further specifies that the insulating material includes oxygen.

Example 26 includes the subject matter of any of Examples 1-25, and further includes: an interconnect structure, wherein the source/drain contact is between the interconnect structure and the channel.

Example 27 includes the subject matter of Example 26, and further specifies that the interconnect structure includes one or more liner materials.

Example 28 includes the subject matter of Example 27, and further specifies that the interconnect structure includes two liner materials.

Example 29 includes the subject matter of any of Examples 26-28, and further specifies that the interconnect structure includes a liner material, and the liner material includes tungsten.

Example 30 includes the subject matter of any of Examples 26-29, and further specifies that the interconnect structure includes a liner material, and the liner material includes tantalum.

Example 31 includes the subject matter of Example 30, and further specifies that the liner material is a first liner material, the interconnect structure includes a second liner material, and the second liner material is between the first liner material and the channel.

Example 32 includes the subject matter of Example 31, and further specifies that the second liner material includes tungsten.

Example 33 includes the subject matter of any of Examples 26-32, and further specifies that the interconnect structure includes a bulk material, and the bulk material includes copper.

Example 34 includes the subject matter of any of Examples 1-33, and further specifies that the back-end transistor is in a metallization stack of an integrated circuit (IC) device.

Example 35 includes the subject matter of any of Examples 1-34, and further specifies that the back-end transistor is part of a memory cell.

Example 36 includes the subject matter of Example 35, and further specifies that the memory cell is a dynamic random access memory (DRAM) cell.

Example 37 includes the subject matter of any of Examples 1-36, and further specifies that a concentration of the element in the interface material decreases towards the channel.

Example 38 is a back-end transistor, including: a channel; and a source/drain contact, wherein the source/drain contact includes an element, and the element is aluminum or cadmium.

Example 39 includes the subject matter of Example 38, and further specifies that the element is aluminum.

Example 40 includes the subject matter of Example 38, and further specifies that the element is cadmium.

Example 41 includes the subject matter of any of Examples 38-40, and further specifies that the source/drain contact includes zinc.

Example 42 includes the subject matter of any of Examples 38-40, and further specifies that the source/drain contact includes tin.

Example 43 includes the subject matter of any of Examples 38-42, and further specifies that the source/drain contact includes oxygen.

Example 44 includes the subject matter of any of Examples 38-43, and further specifies that the element is included in an interface material of the source/drain contact, and the element is present in the interface material in a concentration between 5 atomic-percent and 20 atomic-percent.

Example 45 includes the subject matter of Example 44, and further specifies that the interface material is conductive.

Example 46 includes the subject matter of any of Examples 44-45, and further specifies that the interface material has a U-shaped cross-section.

Example 47 includes the subject matter of any of Examples 44-46, and further specifies that a concentration of the element in the interface material decreases towards the channel.

Example 48 includes the subject matter of any of Examples 38-47, and further specifies that the channel includes indium.

Example 49 includes the subject matter of any of Examples 38-48, and further specifies that the channel includes gallium.

Example 50 includes the subject matter of any of Examples 38-49, and further specifies that the channel includes zinc.

Example 51 includes the subject matter of any of Examples 38-50, and further specifies that the source/drain contact includes copper.

Example 52 includes the subject matter of any of Examples 38-51, and further includes: a gate including a gate dielectric and a gate electrode, wherein the gate dielectric is between the channel and the gate electrode.

Example 53 includes the subject matter of Example 52, and further specifies that the gate dielectric includes hafnium.

Example 54 includes the subject matter of any of Examples 52-53, and further specifies that the gate electrode includes titanium.

Example 55 includes the subject matter of any of Examples 38-54, and further specifies that the source/drain contact is a first source/drain contact, and the transistor further includes: a second source/drain contact.

Example 56 includes the subject matter of Example 55, and further specifies that the second source/drain contact has a same material arrangement as the first source/drain contact.

Example 57 includes the subject matter of any of Examples 55-56, and further includes: an insulating material between the first source/drain contact and the second source/drain contact.

Example 58 includes the subject matter of Example 57, and further specifies that the insulating material includes an interlayer dielectric.

Example 59 includes the subject matter of any of Examples 57-58, and further specifies that the insulating material includes oxygen.

Example 60 includes the subject matter of any of Examples 57-59, and further specifies that the insulating material includes silicon or aluminum.

Example 61 includes the subject matter of any of Examples 57-58, and further specifies that the insulating material includes nitrogen.

Example 62 includes the subject matter of Example 61, and further specifies that the insulating material includes silicon.

Example 63 includes the subject matter of Example 62, and further specifies that the insulating material includes oxygen.

Example 64 includes the subject matter of any of Examples 38-63, and further includes: an interconnect structure, wherein the source/drain contact is between the interconnect structure and the channel.

Example 65 includes the subject matter of Example 64, and further specifies that the interconnect structure includes one or more liner materials.

Example 66 includes the subject matter of Example 65, and further specifies that the interconnect structure includes two liner materials.

Example 67 includes the subject matter of any of Examples 64-66, and further specifies that the interconnect structure includes a liner material, and the liner material includes tungsten.

Example 68 includes the subject matter of any of Examples 64-67, and further specifies that the interconnect structure includes a liner material, and the liner material includes tantalum.

Example 69 includes the subject matter of Example 68, and further specifies that the liner material is a first liner material, the interconnect structure includes a second liner material, and the second liner material is between the first liner material and the channel.

Example 70 includes the subject matter of Example 69, and further specifies that the second liner material includes tungsten.

Example 71 includes the subject matter of any of Examples 64-70, and further specifies that the interconnect structure includes a bulk material, and the bulk material includes copper.

Example 72 includes the subject matter of any of Examples 38-71, and further specifies that the back-end transistor is in a metallization stack of an integrated circuit (IC) device.

Example 73 includes the subject matter of any of Examples 38-72, and further specifies that the back-end transistor is part of a memory cell.

Example 74 includes the subject matter of Example 73, and further specifies that the memory cell is a dynamic random access memory (DRAM) cell.

Example 75 is a computing device, including a support and an integrated circuit (IC) die coupled to the support, wherein the IC die includes a transistor having a channel and a source/drain contact, wherein the source/drain contact includes an interface material, the interface material includes an element, and the element is aluminum, vanadium, zirconium, magnesium, gallium, hafnium, silicon, lanthanum, tungsten, or cadmium.

Example 76 includes the subject matter of Example, and further specifies that the element is aluminum.

Example 77 includes the subject matter of Example, and further specifies that the element is cadmium.

Example 78 includes the subject matter of any of Examples 75-77, and further specifies that the interface material includes indium.

Example 79 includes the subject matter of any of Examples 75-78, and further specifies that the interface material includes zinc.

Example 80 includes the subject matter of any of Examples 75-78, and further specifies that the interface material includes tin.

Example 81 includes the subject matter of any of Examples 75-80, and further specifies that the interface material includes oxygen.

Example 82 includes the subject matter of any of Examples 75-81, and further specifies that the element is present in the interface material in a concentration between 5 atomic-percent and 20 atomic-percent.

Example 83 includes the subject matter of any of Examples 75-82, and further specifies that the interface material is conductive.

Example 84 includes the subject matter of any of Examples 75-83, and further specifies that the interface material has a U-shaped cross-section.

Example 85 includes the subject matter of any of Examples 75-84, and further specifies that the channel includes indium.

Example 86 includes the subject matter of any of Examples 75-85, and further specifies that the channel includes gallium.

Example 87 includes the subject matter of any of Examples 75-86, and further specifies that the channel includes zinc.

Example 88 includes the subject matter of any of Examples 75-87, and further specifies that the source/drain contact includes copper.

Example 89 includes the subject matter of any of Examples 75-88, and further includes: a gate including a gate dielectric and a gate electrode, wherein the gate dielectric is between the channel and the gate electrode.

Example 90 includes the subject matter of Example 89, and further specifies that the gate dielectric includes hafnium.

Example 91 includes the subject matter of any of Examples 89-90, and further specifies that the gate electrode includes titanium.

Example 92 includes the subject matter of any of Examples 75-91, and further specifies that the source/drain contact is a first source/drain contact, and the transistor further includes: a second source/drain contact.

Example 93 includes the subject matter of Example 92, and further specifies that the second source/drain contact has a same material arrangement as the first source/drain contact.

Example 94 includes the subject matter of any of Examples 92-93, and further includes: an insulating material between the first source/drain contact and the second source/drain contact.

Example 95 includes the subject matter of Example 94, and further specifies that the insulating material includes an interlayer dielectric.

Example 96 includes the subject matter of any of Examples 94-95, and further specifies that the insulating material includes oxygen.

Example 97 includes the subject matter of any of Examples 94-96, and further specifies that the insulating material includes silicon or aluminum.

Example 98 includes the subject matter of any of Examples 94-95, and further specifies that the insulating material includes nitrogen.

Example 99 includes the subject matter of Example 98, and further specifies that the insulating material includes silicon.

Example 100 includes the subject matter of Example 99, and further specifies that the insulating material includes oxygen.

Example 101 includes the subject matter of any of Examples 75-100, and further includes: an interconnect structure, wherein the source/drain contact is between the interconnect structure and the channel.

Example 102 includes the subject matter of Example 101, and further specifies that the interconnect structure includes one or more liner materials.

Example 103 includes the subject matter of Example 102, and further specifies that the interconnect structure includes two liner materials.

Example 104 includes the subject matter of any of Examples 101-103, and further specifies that the interconnect structure includes a liner material, and the liner material includes tungsten.

Example 105 includes the subject matter of any of Examples 101-104, and further specifies that the interconnect structure includes a liner material, and the liner material includes tantalum.

Example 106 includes the subject matter of Example 105, and further specifies that the liner material is a first liner material, the interconnect structure includes a second liner material, and the second liner material is between the first liner material and the channel.

Example 107 includes the subject matter of Example 106, and further specifies that the second liner material includes tungsten.

Example 108 includes the subject matter of any of Examples 101-107, and further specifies that the interconnect structure includes a bulk material, and the bulk material includes copper.

Example 109 includes the subject matter of any of Examples 75-108, and further specifies that the transistor is in a metallization stack of the IC die.

Example 110 includes the subject matter of any of Examples 75-109, and further specifies that the transistor is part of a memory cell.

Example 111 includes the subject matter of Example 110, and further specifies that the memory cell is a dynamic random access memory (DRAM) cell.

Example 112 includes the subject matter of any of Examples 75-111, and further specifies that a concentration of the element in the interface material decreases towards the channel.

Example 113 includes the subject matter of any of Examples 75-112, and further specifies that the computing device is a wearable or handheld computing device.

Example 114 includes the subject matter of any of Examples 75-113, and further specifies that the computing device further includes one or more communication chips and an antenna.

Example 115 includes the subject matter of any of Examples 75-114, and further specifies that the support includes a package substrate.

Example 116 includes the subject matter of any of Examples 75-115, and further specifies that the support includes a circuit board.

Example 117 includes the subject matter of Example 116, and further specifies that the circuit board is a motherboard.

## Claims

1. A back-end transistor, comprising:
a channel; and
a source/drain contact, wherein the source/drain contact includes an interface material and a bulk material, the bulk material has a different material composition than the interface material, the interface material is between the bulk material and the channel, the interface material includes indium and an element different from indium, and the element is aluminum, vanadium, zirconium, magnesium, gallium, hafnium, silicon, lanthanum, tungsten, or cadmium.

2. The back-end transistor of claim 1, wherein the element is aluminum.

3. The back-end transistor of claim 1, wherein the element is cadmium.

4. The back-end transistor of any of claims 1-3, wherein the interface material includes zinc.

5. The back-end transistor of any of claims 1-3, wherein the interface material includes tin.

6. The back-end transistor of any of claims 1-3, wherein the interface material includes oxygen.

7. The back-end transistor of any of claims 1-6, wherein the element is present in the interface material in a concentration between 5 atomic-percent and 20 atomic-percent.

8. The back-end transistor of any of claims 1-7, wherein the interface material is conductive.

9. The back-end transistor of any of claims 1-8, wherein the interface material has a U-shaped cross-section.

10. The back-end transistor of any of claims 1-9, wherein the channel includes indium.

11. The back-end transistor of any of claims 1-10, wherein the channel includes gallium.

12. The back-end transistor of any of claims 1-11, wherein the channel includes zinc.

13. The back-end transistor of any of claims 1-12, wherein the bulk material includes copper.

14. A computing device, comprising:
a support; and
an integrated circuit (IC) die coupled to the support, wherein the IC die includes a back-end transistor of any of claims 1-13.

15. The computing device of claim 14, wherein the support includes a package substrate.
